# EUROPEAN PATENT SPECIFICATION

(11) **EP 2 402 983 B1**
(45) Date of publication and mention of the grant of the patent: **25.11.2015**
(21) Application number: 10745896.0
(22) Date of filing: 08.01.2010
(51) Int. Cl.: H01L 21/762

(54) **METHOD FOR MANUFACTURING SOI WAFER**
VERFAHREN ZUR HERSTELLUNG EINES SOI-WAFERS
PROCÉDÉ DE FABRICATION D'UNE TRANCHE SOI

(30) Priority: 26.02.2009 JP 2009043403
(43) Date of publication of application: 04.01.2012
(73) Proprietor: Shin-Etsu Handotai Co., Ltd., Tokyo 100-0004 (JP)
(72) Inventor: AGA, Hiroji, Annaka-shi Gunma 379-0125 (JP); YOKOKAWA, Isao, Annaka-shi Gunma 379-0125 (JP); NOTO, Nobuhiko, Annaka-shi Gunma 379-0125 (JP)
(74) Representative: Wibbelmann, Jobst
(86) International application number: PCT/JP2010/000076
(87) International publication number: WO 2010/098007

(56) References cited:
- EP-A1- 0 935 280
- EP-A2- 1 026 728
- FR-A1- 2 880 184
- JP-A- 11 121 310
- JP-A- 2007 141 946
- JP-T- 2008 526 038

## Description

### TECHNICAL FIELD

The present invention relates to a method for manufacturing an SOI wafer by using so-called an ion implantation delamination method in which the SOI wafer is manufactured by delaminating an ion-implanted wafer after bonding.

### BACKGROUND ART

An ion implantation delamination method is a method for manufacturing an SOI wafer by bonding a base wafer, which is to be a support, to a mirror-polished wafer (a bond wafer) in which a hydrogen ion or a rare gas ion is implanted and thereafter delaminating it at a ion-implanted layer. An SOI layer is not transferred at the outer circumferential portion of the SOI wafer after the delamination, and a terrace portion is produced, in which the surface of the base wafer is exposed. A main cause of this is that bonding strength of the bonded wafer is weak due to lower flatness of wafers at a portion up to approximately several millimeters from the outer circumferential portion of the mirror-polished wafer and thereby the SOI layer is hard to be transferred to the base wafer side.

When the terrace portion of the SOI wafer is observed with an optical microscope, an SOI island is observed, which is the SOI layer being isolated in an island shape at the boundary between the SOI layer and the terrace portion. It is conceivable that this is generated in a transition region between a region having high flatness, in which the SOI layer is transferred, and a region having low flatness, in which the SOI layer is not transferred. It is anticipated that the above-described SOI island will be peeled from the wafer in device fabricating process and become a silicon particle to be reattached to a device fabricating region, and this causes a device failure (See Patent Literature 1).

Moreover, in the ion implantation delamination method, the width of the terrace portion (hereinafter, refer to a terrace width) is determined according to the flatness (the degree of a polishing sag) at the outer circumferential portion of the wafers to be bonded, and it is therefore difficult to control the terrace width after bonding. It is apprehended that for example in case of marking the terrace portion of the SOI wafer with a laser mark and the like during device process, the terrace width is too narrow to mark it.

FR 2 880 184 A1 discloses a method for manufacturing a SOI wafer, wherein the oxide layer is removed in a chamfered region of the wafers to avoid contamination with oxide particles.

### CITATION LIST

### PATENT LITERATURE

Patent Literature 1:Japanese Unexamined Patent publication (Kokai) No.2002-305292

### SUMMARY OF INVENTION

The present invention was accomplished in view of the above-explained circumstances to provide a method for manufacturing an SOI wafer that enables the terrace width, which is generated in case of the delamination by the ion implantation delamination method, to be controlled and the SOI island of the terrace portion, which causes a lower yield, to be suppressed.

To solve this object, the present invention provides a method for manufacturing an SOI wafer as disclosed in claim 1.

In this manner, when the insulator film located between the bond wafer and the base wafer is etched from the outer circumferential edge toward the center of the bonded wafer, the terrace width can be controlled and the generation of the SOI island, which is a peculiar defect to the case of the delamination by the ion implantation delamination method, can be prevented.

Moreover, it is preferable that the bond wafer is bonded to the base wafer at a room temperature, a heat treatment is not performed successively, and thereafter the insulator film is etched.

In this manner, when the bond wafer is bonded to the base wafer at a room temperature, the wafers can be bonded to one another without using an adhesive and the like. In addition, when a heat treatment is not performed successively and thereafter the insulator film is etched, the bond wafer can be prevented from being delaminated at the ion-implanted layer before the etching of the insulator film, the terrace width can be controlled more accurately, and thereby the SOI island can be prevented.

Moreover, it is preferable that the bond wafer is bonded to the base wafer at a room temperature, and thereafter the insulator film is etched after performing a low temperature heat treatment in which the delamination at the ion-implanted layer does not occur.

In this manner, when the bond wafer is bonded to the base wafer at a room temperature, and thereafter the insulator film is etched after performing a low temperature heat treatment in which the delamination at the ion-implanted layer does not occur, the terrace width can be controlled more accurately to prevent the SOI island.

Moreover, the insulator film is etched in the range of not less than 0.5 mm and not more than 10 mm from the outer circumferential edge toward the center of the bonded wafer.

In this manner, when the insulator film is etched in the range of not less than 0.5 mm and not more than 10 mm from the outer circumferential edge toward the center of the bonded wafer, an appropriate terrace width can be obtained in case of marking the terrace portion with a laser mark and the like during device process, and the generation of the SOI island can be more surely prevented.

Moreover, the insulator film can be etched by using the bonded wafer having an oxide film, a nitride film or a laminated structure thereof as the insulator film, and immersing the bonded wafer into an aqueous solution containing HF or a phosphoric acid solution. Alternatively, the insulator film can be etched by using the bonded wafer having a native oxide film as the insulator film.

Moreover, it is preferable that the bonded wafer after etching the insulator film is immersed into a liquid capable of dissolving the silicon single crystal or exposed to a gas capable of dissolving the silicon single crystal so that an outer circumferential edge portion of the bond wafer ranging from a bonded surface side to at least a depth of the ion-implanted layer is etched up to at least an outer circumferential edge of the etched insulator film (hereinafter, Si etching), and thereafter the bond wafer is delaminated.

The above-described Si etching enables a portion that can be an extraneous substance in device fabricating process to be removed in advance.

As explained above, with the method for manufacturing an SOI wafer according to the present invention, the terrace width can be controlled and the generation of the SOI island, which is a peculiar defect to the case of the delamination by the ion implantation delamination method, can be prevented.

### BRIEF DESCRIPTION OF THE DRAWINGS

FIG. 1 is a explanatory view showing the method for manufacturing an SOI wafer according to the present invention;
FIG. 2 is a view showing another method for manufacturing an SOI wafer according to the present invention;
FIG. 3 shows microscope photographs obtained by observing an erosion state from the outer circumferential edge of the oxide film of the bond wafer side, depending on the change in immersion conditions (HF aqueous solution concentration and immersion time) at the time of immersing the bonded wafer into an HF aqueous solution; and
FIG. 4 is a flowchart for observing an erosion state from the outer circumferential edge of the oxide film of the bond wafer side, depending on the change in immersion conditions (HF aqueous solution concentration and immersion time) at the time of immersing the bonded wafer into an HF aqueous solution.

### DESCRIPTION OF EMBODIMENTS

Hereinafter, the present invention will be explained in detail.

The present inventors conducted studies on the cause of the generation of the SOI island in order to suppress the SOI island, which is a peculiar defect generated during manufacture of the SOI wafer by the ion implantation delamination method. As a result, the present inventors thought as follows. When the insulator film located between the bond wafer and the base wafer is etched and removed up to a certain degree range from the outer circumferential edge toward the center thereof, before the delamination of the bond wafer at the ion-implanted layer, the region of weak bonding strength, which causes the SOI island, is not produced, and therefore the SOI layer can be surely prevented from being transferred to the region where the SOI island is easy to be produced, by preventing a halfway SOI layer from being transferred. The SOI island can be consequently prevented from being generated.

It is necessary for this to immerse the bonded wafer into an etching solution for the insulator film, such as hydrofluoric acid, phosphoric acid, and the like before the delamination of the bond wafer. Since it is apprehended that erosion of a bonding interface with the etching solution is caused by immersing the bonding interface in low bonding strength state into the etching solution, it is conventionally considered that a bonding heat treatment at a high temperature (for example, 1000°C or more) is needed before immersing it into the etching solution, for example, as described in Japanese Unexamined Patent publication (Kokai) No.H10-70054.

In case of the ion implantation delamination method, however, the above-described high temperature heat treatment prior to etching causes the delamination of the bond wafer, and therefore the SOI island, which is a peculiar defect to the ion implantation delamination method, cannot be prevented.

In view of this, the present inventors investigated the degree of etching progress at the bonding interface in the case of immersing the wafer bonded at a room temperature into the etching solution. As a result, the present inventors found that, in case of a wafer obtained by bonding a silicon oxide film to a bare silicon, the immersion of the bonding interface was stopped at approximately 10 mm from the outer circumference even when it was immersed into a 50% HF aqueous solution for one day (24 hours), and therefore the amount of etching can be controlled. The present inventors thereby brought the present invention to completion.

Hereinafter, the method for manufacturing an SOI wafer according to the present invention will be explained in detail, but the present invention is not restricted thereto.

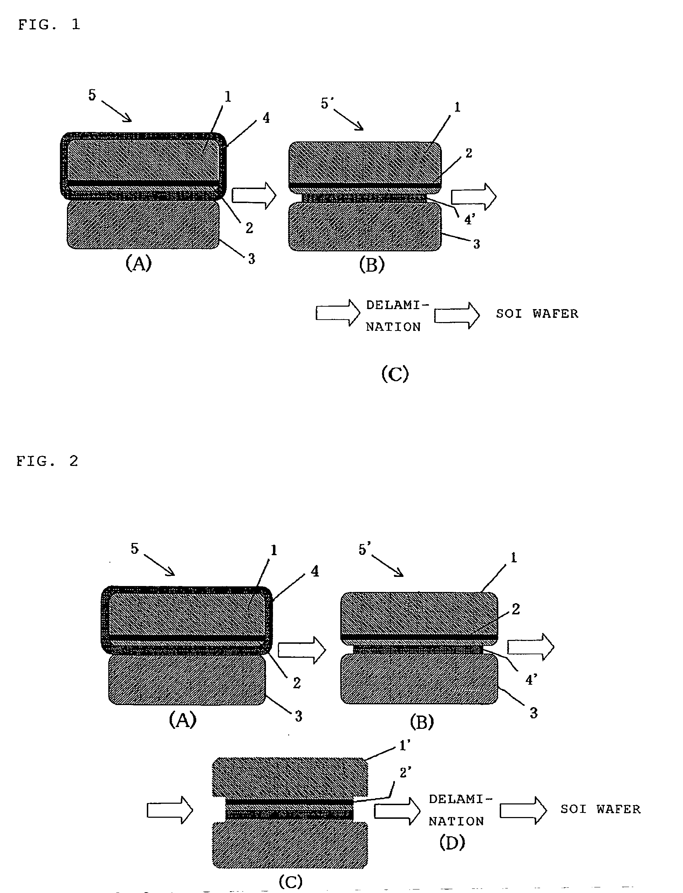

Specifically, as shown in FIG. 1, the present invention is a method for manufacturing an SOI wafer, including the steps of: implanting at least one gas ion of a hydrogen ion and a rare gas ion into the silicon single crystal bond wafer 1 from the surface thereof to form the ion-implanted layer 2; bonding the ion-implanted surface of the bond wafer 1 to the surface of the base wafer 3 through the insulator film 4 (FIG. 1(A)); immersing the bonded wafer 5 prior to the delamination of the bond wafer 1 at the ion-implanted layer 2 into a liquid capable of dissolving the insulator film 4 or exposing the bonded wafer to a gas capable of dissolving the insulator film 4 so that the insulator film 4 located between the bond wafer 1 and the base wafer 3 is etched from the outer circumferential edge toward the center of the bonded wafer 5 to obtain the insulator film 4' after etching the insulator film (FIG. 1(B)); and thereafter delaminating the bond wafer 1 at the ion-implanted layer 2 (FIG. 1(C)).

In the present invention, the bond wafer 1 is preferably bonded to the base wafer 3 at a room temperature. When the surfaces of two wafers are brought into contact with one another through the insulator film 4 at a room temperature, the wafers are bonded to one another without using an adhesive and the like. Moreover, when a heat treatment is not performed successively or a low temperature heat treatment (for example, 400°C or less) is performed in which the delamination of the bond wafer 1 at the ion-implanted layer 2 does not occur, and thereafter the insulator film 4 is etched, the bond wafer 1 can be prevented from being delaminated at the stage prior to etching, which is conventionally apprehended in case of using the ion implantation delamination method, and the terrace width can be controlled more accurately.

As a method for etching the insulator film 4, there are a method of immersing the bonded wafer 5 into a liquid capable of dissolving the insulator film and etching by exposing the bonded wafer to a gas capable of dissolving the insulator film. The insulator film at the bonding interface is eroded from the outer circumferential edge by etching. When the insulator film is eroded as above, the SOI layer is not transferred at the time of delaminating the bond wafer after etching, and the eroded portion consequently becomes the terrace region because the bond wafer and the base wafer are not bonded to one another thereat. On the other hand, in case of the insulator film (the region where the insulator film remains) 4' after etching the insulator film, the SOI layer is transferred by the delamination. That is, a erosion width by etching can be made to be the terrace width, and the width can be controlled by etching conditions, such as etching time, the concentration of the etching solution to be used, temperature, and the like.

When the insulator film is an oxide film, the etching solution is preferably HF aqueous solution. Buffered hydrofluoric acid, HF/H₂O₂/CH₃COOH aqueous solution, HF/HNO₃ aqueous solution may be also applied. When the insulator film is a nitride film, phosphoric acid solution is preferably used.

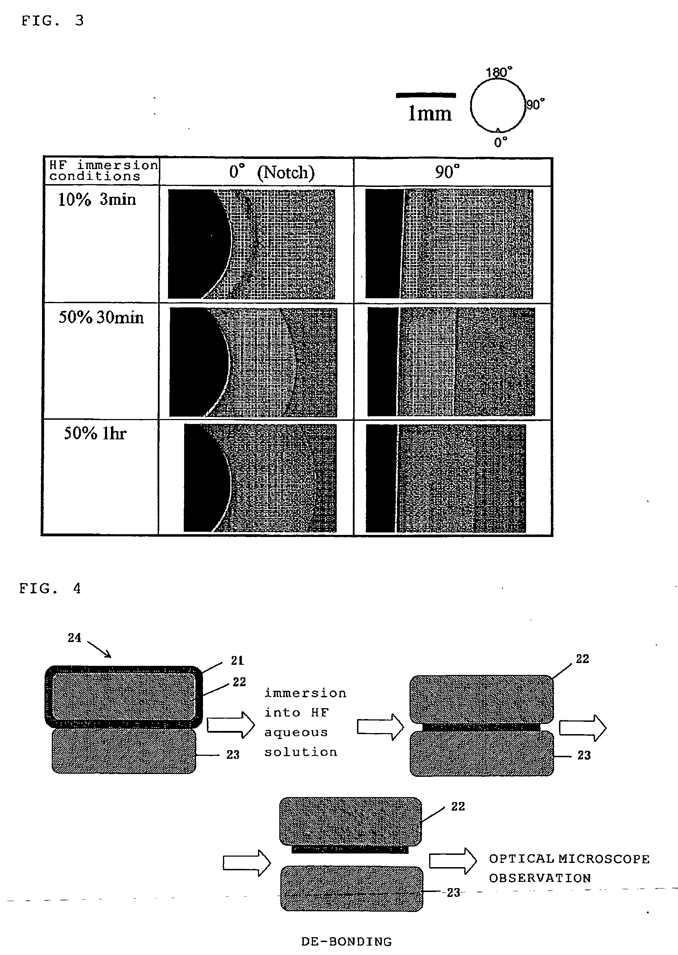

Here, FIG. 3 shows microscope photographs obtained by observing an erosion state from the outer circumferential edge of the oxide film of the bond wafer side, depending on the change in HF concentration and immersion time, by means of bonding the silicon single crystal bond wafer 22 with the oxide film 21 to the silicon single crystal base wafer 23 at a room temperature (25°C) to produce the bonded wafer 24, immersing the bonded wafer 24 into an HF aqueous solution (25°C) without performing a heat treatment on the bonded wafer 24, and thereafter separating the bond wafer and the base wafer at a bonding surface (de-bonding), as shown in FIG. 4. It is to be noted that immersion conditions into an HF aqueous solution are 10%·3 minutes, 50%·30 minutes, and 50%·1hr (HF aqueous solution concentration·immersing time).

FIG. 3 shows that each terrace width changes depending on the concentration of HF aqueous solution and the immersing time.

The erosion width from the outer circumference of the insulator film at the time of the above-described etching changes depending on the type of insulator film and the type, concentration, and temperature of etching solution. The erosion width can be controlled by etching time under the same conditions, and thus the terrace width after transferring the SOI layer can be readily controlled.

On the other hand, the SOI island is generated at the boundary between the SOI layer and terrace portion. This is a region where the bonding strength is weak due to low flatness at the outer circumferential portion of the wafers to be bonded and thereby the SOI layer is only partially transferred. In order to suppress the generation of the SOI island, the erosion width of the insulator film is expanded up to the region where the SOI island is produced by the above-described etching of the insulator film (for example, the range of not less than 0.5 mm and not more than 10 mm from the outer circumferential edge toward the center of the bonded wafer) so that the SOI layer is not transferred at the region of low bonding strength, which causes the SOI island. The SOI island is thereby not generated.

The SOI island is a peculiar defect to the ion implantation delamination method. However, the method for controlling the terrace width can be applied to not only the ion implantation delamination method but also SOI manufacturing by the other bonding method, such as grinding and polishing.

As the insulator film, an oxide film, a nitride film, or a laminated structure thereof is commonly used, but this is not restricted in particular. Moreover, the method for manufacturing an SOI wafer according to the present invention is also favorably applied to the case of the bonded wafer having a native oxide film as the insulator film, namely, the case of bonding wafers having only a native oxide film, and useful for controlling the terrace width and suppressing the generation of the SOI island. Further, the bonding strength at a room temperature can be also improved by performing a plasma treatment on the bonding surface before bonding.

As shown in FIG. 2, the bonded wafer 5' (FIG. 2 (B)) after etching the insulator film 4 (FIG. 2(A)) of the bonded wafer 5 by the above-described method may also be immersed into a liquid capable of dissolving the silicon single crystal or exposed to a gas capable of dissolving the silicon single crystal so that the outer circumferential portion of the bond wafer 1 ranging from a bonded interface side to at least the depth of the ion-implanted layer 2 is etched up to at least the outer circumferential edge of the etched insulator film 4' (FIG. 2(C)), and thereafter the bond wafer 1 is delaminated (FIG. 2(D)). It is to be noted that, in FIG. 2(C), symbol 1' shows the bond wafer after Si etching and 2' shows the ion-implanted layer after Si etching.

As described above, when the outer circumferential portion of the bond wafer 1 ranging from the bonded interface side to at least the depth of the ion-implanted layer 2 is Si-etched up to at least the outer circumferential edge of the etched insulator film 4', a portion that may become an extraneous substance in device fabricating process can be removed in advance. This enables the SOI island to surely prevent from being generated. In addition, the ion-implanted layer at the outer circumferential portion of the bond wafer is removed, and a blistering at the outer circumferential portion is not generated by heat treatment to be performed in subsequent process. Si chips, which are caused by the blistering generated even when the heat treatment is performed to the ion-implanted layer at the outer circumferential portion of the bond wafer, can be therefore prevented from attaching to the terrace portion of the SOI wafer. It is to be noted that the attached Si chips are not combined with the base wafer, unlike the SOI island, and can be removed to a certain degree by general cleaning. It is however difficult to remove it completely, and therefore the attached Si chips are desirably suppressed.

As the liquid capable of dissolving the silicon single crystal, for example, a TMAH (tetramethyl ammonium hydroxide) aqueous solution and the like is exemplified. However, this is not restricted as long as it is a liquid capable of dissolving the silicon single crystal or a gas capable of dissolving the silicon single crystal.

Moreover, the outer circumference, except for a desirable range to be subjected to the Si-etching from the bonded interface side of the bond wafer to at least the depth of the ion-implanted layer, is preferably protected by previously masking so as not to etch the outer circumference of the bond wafer and the base wafer, before performing the Si etching.

### EXAMPLE

Hereinafter, the present invention will be explained in detail with reference to Examples and Comparative Example, but the present invention is not restricted thereto.

### (Example 1)

Hydrogen ions were implanted in conditions of Table 1 described below into the bond wafer obtained by forming a thermal oxide film of 150 nm on the surface of a silicon single crystal wafer having a diameter of 300 mm. The bond wafer was bonded to a silicon single crystal base wafer having a diameter of 300 mm at a room temperature. The bonded wafer was immersed into a 50% HF aqueous solution for 30 minutes after the bonding. A delamination heat treatment was thereafter performed at 500°C for 30 minutes to delaminate the bond wafer, and thereby the SOI wafer was manufactured. Table 1 shows the conditions of the SOI wafer manufacture and the result of observing the terrace portion with an optical microscope after delaminating the bond wafer.

The terrace width was 1.6 mm, and the SOI island was not observed. It was observed that Si chips, which were caused by the blistering generated at the ion-implanted layer of the outer circumferential portion of the bond wafer during the delamination heat treatment, was attached on the terrace portion.

### (Example 2)

The bond wafer was bonded to the base wafer in the same conditions as Example 1, and immersed into a 50% HF aqueous solution for 1 hour after the bonding. It was thereafter immersed into a TMAH aqueous solution to perform Si-etching of the outer circumferential portion of the bond wafer up to 2 µm depth from the bonding interface, as shown in FIG. 2(C). The delaminating heat treatment was thereafter performed at 500°C for 30 minutes to delaminate the bond wafer, and the SOI wafer was thereby manufactured. Table 1 shows the conditions of the SOI wafer manufacture and the result of observing the terrace portion with an optical microscope after the delamination.

The terrace width was 1.8 mm, and the SOI island was not observed. In addition, the Si chips were not attached to the terrace portion at all.

### (Comparative Example)

Hydrogen ions were implanted in conditions of Table 1 described below into the bond wafer obtained by forming a thermal oxide film of 150 nm on the surface of a silicon single crystal wafer having a diameter of 300 mm. The bond wafer was bonded to a silicon single crystal base wafer having a diameter of 300 mm at a room temperature. A delamination heat treatment was thereafter performed at 500°C for 30 minutes to delaminate the bond wafer, and the SOI wafer was thereby manufactured. Table 1 shows the conditions of the SOI wafer manufacture and the result of observing the terrace portion with an optical microscope after delaminating the bond wafer.

The terrace width was 1.4 mm, and the SOI island and the attachment of the Si chips were observed.

**(Table 1)**

| | COMPARATIVE EXAMPLE | EXAMPLE 1 | EXAMPLE 2 |
|---|---|---|---|
| BURIED OXIDE FILM (BOND WAFER) | Ox=150nm | Ox=150nm | Ox=150nm |
| ION IMPLANTATION (BOND WAFER) | 40keV, 6×10¹⁶cm⁻² | 40keV, 6×10¹⁶cm⁻² | 40keV, 6×10¹⁶cm⁻² |
| STEP OF BONDING | ROOM TEMPERATURE BONDING | ROOM TEMPERATURE BONDING | ROOM TEMPERATURE BONDING |
| ETCHING CONDITIONS (HF AQUEOUS SOLUTION CONCENTRATION, IMMERSING TIME) | NONE | HF 50% 30 min | HF 50% 1 hr + ETCHING OF Si BY 2µm WITH TMAH AQUEOUS SOLUTION |
| TEMPERATURE AND TIME OF DELAMINATION HEAT TREATMENT | 500°C, 30min | 500°C, 30min | 500°C, 30min |
| OBSERVATION OF TERRACE AFTER DELAMINATION (OPTICAL MICROSCOPE) | TERRACE WIDTH:1.4mm SOI ISLAND: EXISTENCE Si CHIPS: ATTACHED | TERRACE WIDTH:1.6mm SOI ISLAND: NONEXISTENCE Si CHIPS: ATTACHED | TERRACE WIDTH:1.8mm SOI ISLAND: NONEXISTENCE Si CHIPS: NO ATTACHED |

As shown in Table 1, in Example 1 and Example 2, the terrace width was able to be controlled by etching time, and moreover the generation of the SOI island, which is a peculiar defect to the ion implantation delamination method, was able to be prevented. Particularly in Example 2, the attachment of the Si chips were able to be prevented completely. On the other hand, in Comparative Example, the SOI island and the attachment of the Si chips were observed.

It is to be noted that the present invention is not restricted to the foregoing embodiment. The embodiment is just an exemplification, and any examples that have substantially the same feature and demonstrate the same functions and effects as those in the technical concept described in claims of the present invention are included in the technical scope of the present invention.

## Claims

1. A method for manufacturing an SOI wafer comprising the steps of:
implanting at least one gas ion of a hydrogen ion and a rare gas ion into a silicon single crystal bond wafer (1) from a surface thereof to form an ion implanted layer (2);
bonding the ion-implanted surface of the bond wafer to a surface of a base wafer (3) through an insulator film (4); and
delaminating the bond wafer at the ion-implanted layer to manufacture the SOI wafer,
the method further comprising the step of immersing the bonded wafer prior to the delamination of the bond wafer at the ion-implanted layer into a liquid capable of dissolving the insulator film or exposing the bonded wafer to a gas capable of dissolving the insulator film, **characterised in that** the insulator film located between the bond wafer and the base wafer is etched in the range of not less than 0.5 mm and not more than 10 mm from an outer circumferential edge toward a center of the bonded wafer.

2. The method for manufacturing an SOI wafer according to claim 1, wherein the bond wafer is bonded to the base wafer at a room temperature, a heat treatment is not performed successively, and thereafter the insulator film is etched.

3. The method for manufacturing an SOI wafer according to claim 1, wherein the bond wafer is bonded to the base wafer at a room temperature, and thereafter the insulator film is etched after performing a low temperature heat treatment in which the delamination at the ion-implanted layer does not occur.

4. The method for manufacturing an SOI wafer according to any one of claims 1 to 3, wherein the insulator film is etched by using the bonded wafer having an oxide film, a nitride film or a laminated structure thereof as the insulator film, and immersing the bonded wafer into an aqueous solution containing HF or a phosphoric acid solution.

5. The method for manufacturing an SOI wafer according to any one of claims 1 to 4, wherein the insulator film is etched by using the bonded wafer having a native oxide film as the insulator film.

6. The method for manufacturing an SOI wafer according to any one of claims 1 to 5, wherein the bonded wafer after etching the insulator film is immersed into a liquid capable of dissolving the silicon single crystal or exposed to a gas capable of dissolving the silicon single crystal so that an outer circumferential edge portion of the bond wafer ranging from a bonded surface side to at least a depth of the ion-implanted layer is etched up to at least an outer circumferential edge of the etched insulator film, and thereafter the bond wafer is delaminated.

## Patentansprüche

1. Verfahren zum Herstellen eines SOI Wafers umfassend die Schritte:
Implantieren von mindestens einem Gas-Ion eines Wasserstoff-Ions und eines Edelgas-Ions in einen Silizium-Einkristall-Bond-Wafer (1) von einer Oberfläche davon, um eine ionen-implantierte Schicht (2) zu bilden;
Bonden der ionen-implantieren Oberfläche des Bond-Wafers an eine Oberfläche eines Basis-Wafers über einen Isolatorfilm (4); und
Delaminieren des Bond-Wafers an der ionen-implantieren Schicht um den SOI Wafer herzustellen,
wobei das Verfahren des Weiteren den Schritt des Eintauchens des gebondeten Wafers vor der Delaminierung des Bond-Wafers an der ionen-implantieren Schicht in eine Flüssigkeit, die fähig ist, den Isolatorfilm zu lösen, oder Aussetzen des gebondeten Wafer einem Gas, das fähig ist den Isolatorfilm zu lösen, umfasst,
**dadurch gekennzeichnet, dass** der Isolatorfilm, der zwischen dem Bond-Wafer und dem Basis-Wafer angeordnet ist, im Bereich von nicht weniger als 0,5 mm und nicht mehr als 10 mm von einem äußeren umlaufenden Rand in Richtung eines Zentrums des gebondeten Wafers geätzt wird.

2. Verfahren zum Herstellen eines SOI Wafers nach Anspruch 1, wobei der Bond-Wafer bei Raumtemperatur an den Basis-Wafer gebondet wird, keine Wärmebehandlung darauffolgend durchgeführt wird und danach der Isolatorfilm geätzt wird.

3. Verfahren zum Herstellen eines SOI Wafers nach Anspruch 1, wobei der Bond-Wafer bei Raumtemperatur an den Basis-Wafer gebondet wird, und danach der Isolatorfilm nach Durchführen einer Niedrigtemperatur-Wärmebehandlung geätzt wird, in welcher die Delaminierung an der ionen-implantierten Schicht nicht stattfindet.

4. Verfahren zum Herstellen eines SOI Wafers nach einem Beliebigen der Ansprüche 1 bis 3, wobei der Isolatorfilm unter Verwendung des gebondeten Wafers mit einem Oxidfilm, einem Nitridfilm, oder einer laminierten Struktur davon als Isolatorfilm, geätzt wird, und Eintauchen des gebondeten Wafers in eine wässrige Lösung die HF oder eine Phosphorsäurelösung enthält.

5. Verfahren zum Herstellen eines SOI Wafers nach einem Beliebigen der Ansprüche 1 bis 4, wobei der Isolatorfilm unter Verwendung des gebondeten Wafers mit einem nativen Oxidfilm als Isolatorfilm gebondet wird.

6. Verfahren zum Herstellen eines SOI Wafers nach einem Beliebigen der Ansprüche 1 bis 5, wobei der gebondete Wafer nach Ätzen des Isolatorfilms in eine Flüssigkeit eingetaucht wird, die fähig ist den Silizium-Einkristall zu lösen oder an ein Gas ausgesetzt wird, das fähig ist, den Silizium-Einkristall zu lösen, so dass ein äußerer umlaufender Randteil des Bond-Wafers, der von einer gebondeten Oberflächenseite zu mindestens einer Tiefe der ionen-implantierten Schicht reicht, bis zu mindestens einem äußeren umlaufenden Rand des geätzten Isolatorfilms geätzt wird und danach der Bond-Wafer delaminiert wird.

## Revendications

1. Procédé de fabrication d'une plaquette de SOI comprenant les étapes de :
implantation d'au moins un ion gazeux d'un ion hydrogène et d'un ion de gaz rare dans une plaquette de liaison de monocristal de silicium (1) à partir d'une surface de celle-ci pour former une couche à implantation ionique (2) ;
liaison de la surface à implantation ionique de la plaquette de liaison à une surface d'une plaquette de base (3) par l'intermédiaire d'un film d'isolateur (4) ; et
décollage de la plaquette de liaison au niveau de la couche à implantation ionique pour fabriquer la plaquette de SOI,
le procédé comprenant en outre l'étape d'immersion de la plaquette liée avant le décollage de la plaquette de liaison au niveau de la couche à implantation ionique dans un liquide apte à dissoudre le film d'isolateur ou d'exposition de la plaquette liée à un gaz apte à dissoudre le film d'isolateur, **caractérisé en ce que** le film d'isolateur situé entre la plaquette de liaison et la plaquette de base est gravé dans la plage de pas moins de 0,5 mm et pas plus de 10 mm à partir d'un bord circonférentiel extérieur vers un centre de la plaquette liée.

2. Procédé de fabrication d'une plaquette de SOI selon la revendication 1, dans lequel la plaquette de liaison est liée à la plaquette de base à la température ambiante, un traitement thermique n'est pas effectué successivement, et ensuite le film d'isolateur est gravé.

3. Procédé de fabrication d'une plaquette de SOI selon la revendication 1, dans lequel la plaquette de liaison est liée à la plaquette de base à la température ambiante, et ensuite le film d'isolateur est gravé après exécution d'un traitement thermique basse température dans lequel le décollage au niveau de la couche à implantation ionique ne survient pas.

4. Procédé de fabrication d'une plaquette de SOI selon l'une quelconque des revendications 1 à 3, dans lequel le film d'isolateur est gravé en utilisant la plaquette liée ayant un film d'oxyde, un film de nitrure ou une structure stratifiée de ceux-ci comme le film d'isolateur, et en immergeant la plaquette liée dans une solution aqueuse contenant HF ou une solution d'acide phosphorique.

5. Procédé de fabrication d'une plaquette de SOI selon l'une quelconque des revendications 1 à 4, dans lequel le film d'isolateur est gravé en utilisant la plaquette liée ayant un film d'oxyde natif comme le film d'isolateur.

6. Procédé de fabrication d'une plaquette de SOI selon l'une quelconque des revendications 1 à 5, dans lequel la plaquette liée après gravure du film d'isolateur est immergée dans un liquide apte à dissoudre le monocristal de silicium ou exposée à un gaz apte à dissoudre le monocristal de silicium de façon à ce qu'une partie de bord circonférentiel extérieur de la plaquette de liaison allant d'un côté de surface liée jusqu'à au moins une profondeur de la couche à implantation ionique soit gravée jusqu'à au moins un bord circonférentiel extérieur du film d'isolateur gravé, et ensuite la plaquette de liaison est décollée.
